# EUROPEAN PATENT APPLICATION

(11) **EP 2 453 472 A1**
(43) Date of publication of application: **16.05.2012**
(21) Application number: 10191347.3
(22) Date of filing: 16.11.2010
(51) Int. Cl.: H01L 21/673, H01L 21/677

(54) **Pallet For High Temperature Processing**

(71) Applicant: Applied Materials, Inc., Santa Clara, CA 95054 (US)
(72) Inventor: Hoffmann, Josef, 63839, Kleinwallstadt (DE); Bergmann, Tobias, 63755, Alzenau (DE); Groth, Soenke, 63450, Hanau (DE); Alt, Horst, 63543, Neuberg (DE)
(74) Representative: Schley, Jan Malte

(57) **Abstract**

A generally planar substrate pallet having an front, a back, and pair of sides. The distance between the front and the back and the distance between the sides are significantly longer than the thickness of the substrate pallet. The ratio of vertical deflection of the substrate pallet to the distance between the sides at temperatures used in high temperature processing systems relative to room temperature is less than 1%.

## Description

This disclosure relates to pallets for wafers and other substrates. The pallets are suited to high temperature processing of such substrates.

Wafers and other substrates can be processed to fabricate a variety of different devices, including solar cells and microelectronic devices. The processing used to fabricate devices can at times require relatively high temperatures. For example, some sputtering processes can raise the temperature of a substrate to 500°C or more.

### SUMMARY

This disclosure describes pallets for wafers and other substrates. The pallets are suited to high temperature processing of such substrates, including high temperature sputtering.

In a first aspect, a device includes a generally planar substrate pallet having an front, a back, and pair of sides, wherein the distance between the front and the back and the distance between the sides are significantly longer than the thickness of the substrate pallet. The ratio of vertical deflection of the substrate pallet to the distance between the sides at temperatures used in high temperature processing systems relative to room temperature is less than 1%.

In a second aspect, a device includes a generally planar substrate pallet having an front, a back, and pair of sides, wherein the distance between the front and the back and the distance between the sides are significantly longer than the thickness of the substrate pallet. The bending moment of inertia of the substrate pallet distance between the sides is larger than the bending moments of inertia between the front and the back.

In a third aspect, a device includes a generally planar substrate pallet having an front, a back, and pair of sides, wherein the distance between the front and the back and the distance between the sides are significantly longer than the thickness of the substrate pallet. The generally planar substrate pallet comprises a pair of elongate contact members and at least one elongate cross member coupled to each of the contact members.

In a fourth aspect, a device includes a generally planar substrate pallet having an front, a back, and pair of sides, wherein the distance between the front and the back and the distance between the sides are significantly longer than the thickness of the substrate pallet. The device comprises a generally planar substrate mounting plate coupled to the substrate pallet at a single fixed point.

The first, second, third, fourth, and other aspects can include one or more of the following features. The ratio of vertical deflection to the distance between the sides can be less than less than 0.3%. The bending moment of inertia of the substrate pallet distance between the sides can be larger than the bending moments of inertia between the front and the back. The generally planar substrate pallet can include a pair of elongate contact members and at least one elongate cross member coupled to each of the contact members. The elongate contact members and the at least one elongate cross member can all be made from heat resistant steel. The at least one elongate cross member can have a U-shaped cross-section. The elongate contact members can be coupled to the at least one elongate cross member by intermediate members. Each of the intermediate members can have an L-shaped lateral cross-section. Each of the intermediate members can include a body coupled to a respective of the cross members and an extension coupled to a respective of the at least one elongate contact members. The at least one elongate cross member can be a pair of elongate cross members disposed along outer boundaries of the y-dimension of the substrate pallet. The device can include at least one elongate support beam disposed across the cross member but slidable relative thereto. The cross member can include a receptacle dimensioned to receive a portion of the elongate support beam. The portion of the elongate support beam can be slidably received in the receptacle. The device can include a generally planar substrate mounting plate coupled to the substrate pallet at a single fixed point. The substrate mounting plate can be coupled to a pair of elongate contact members disposed along outer boundaries of the x-dimension of the substrate pallet.

A method can include loading substrates onto a device according to any one of the first, second, third, fourth, and other aspects with or without the features described above, transporting the substrate pallet and substrates loaded thereon into a sputtering deposition device with the x-dimension generally orthogonal to the direction of transport and the y-dimension generally parallel to the direction of transport, and sputter depositing a film onto the substrates in the sputtering deposition device.

The details of one or more implementations are set forth in the accompanying drawings and the description below. Other features and advantages will be apparent from the description and drawings, and from the claims.

### DESCRIPTION OF DRAWINGS

FIG. 1 is a schematic representation of a pallet.
FIG. 2 is a schematic representation of an example pallet that is adapted for use in high temperature processing systems.
FIG. 3 is a schematic representation of an example pallet that is adapted for use in high temperature processing systems.
FIGS. 4, 5 are a schematic representations of examples of portions of front and back members of an example pallet that is adapted for use in high temperature processing systems.
FIG. 6 is a schematic representation of one example of a coupling between a side contact member and a back member in a pallet that is adapted for use in high temperature processing systems.
FIG. 7 is a schematic representation of an example of a portion of front and back members in a pallet that is adapted for use in high temperature processing systems.
FIG. 8 is a schematic representation of one example of a coupling between a side contact member and a back member in a pallet that is adapted for use in high temperature processing systems.
FIG. 9 is a schematic representation of one example of how an intermediate coupling member can mediate coupling between a side contact member and a back member in a pallet that is adapted for use in high temperature processing systems.
FIG. 10 is a schematic representation of an example pallet that is adapted for use in high temperature processing systems.
FIGS. 11 and 13 are schematic representations of example ends of a support beam in a pallet that is adapted for use in high temperature processing systems.
FIGS. 12 and 14 are schematic representations of cross-sections of couplings of ends of a support beam to members in a pallet that is adapted for use in high temperature processing systems.
FIG. 15 is a schematic representation of an example pallet that is adapted for use in high temperature processing systems.

Like reference symbols in the various drawings indicate like elements.

### DETAILED DESCRIPTION

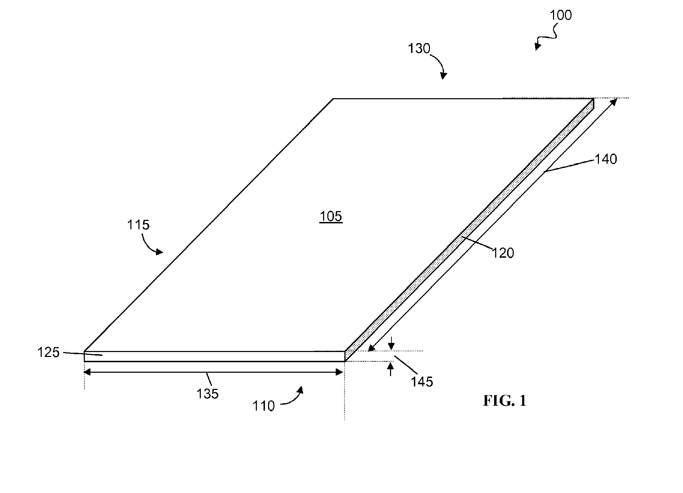

FIG. 1 is a schematic representation of a pallet 100. Pallet 100 is a portable platform for handling or storing substrates during processing, including high temperature processing. Pallet 100 can be loaded to support a number of substrates simultaneously. A loaded pallet 100 can generally be handled or stored more easily than the individual substrates can be handled or stored. As described further below, pallet 100 can have any of a number of different features that are adapted for use in high temperature processing systems.

Pallet 100 includes a top 105, a bottom 110, a front 115, a back 120, and a pair of sides 125, 130. Pallet 100 can span a distance 135 between front 115 and back 120 (hereinafter the "x-dimension"). Pallet 100 can span a distance 140 between sides 125, 130 (hereinafter the "y-dimension"). Pallet 100 can also span a thickness 145 between top 105 and bottom 110 (hereinafter the "z-dimension"). Thickness 145 can be significantly shorter than distances 135, 140, giving pallet 100 a generally planar shape as shown. Substrates can be loaded onto and supported by pallet 100, e.g., on top 105, on bottom 110, between top 105 and bottom 110, or in combinations of such arrangements.

In some processing systems, pallet 100 is introduced into the processing system front-first, i.e., with front 115 leading and back 120 following. In some processing systems, contact is made with pallet 100 at sides 125, 130. For example, as described further below, sides 125, 130 can include one or more contact members that include surfaces contacted by handling and/or storage devices.

Pallet 100 can be made primarily from metals that have low vapor pressures at the temperatures and pressures at which wafers or other substrates are to be processed In particular, the vapor pressures must be low enough pallet 100 does not contaminate the processing. Such metals, including stainless steels, outgas less than materials such as carbon fiber-enhanced plastics, are less expensive, and easier to clean.

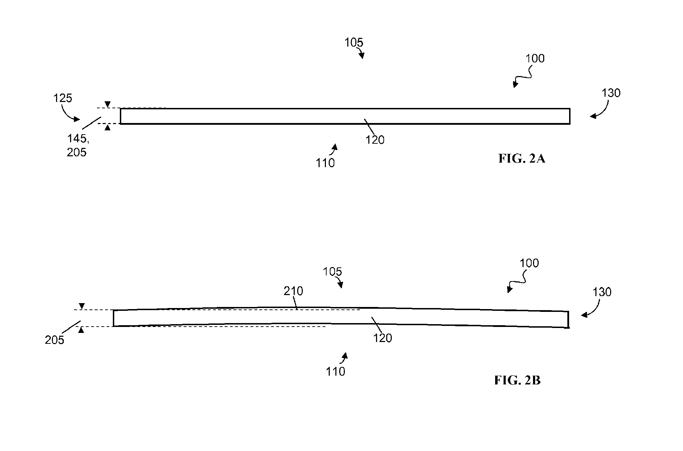

FIGS. 2A, 2B are schematic representations of side views of an example pallet 100 at room temperature (FIG. 2A) and at temperatures used in high temperature processing systems (FIG. 2B). The illustrated implementation of pallet 100 has been constructed to resist thermal deflection between sides 125, 130 notwithstanding the temperature change.

In the illustrated implementation, pallet 100 is flat at room temperature (FIG. 2A). This flatness is schematically represented by showing the entire thickness 145 of pallet 100 being found within a span 205. However, at temperatures used in high temperature processing systems, pallet 100 deflects between sides 125, 130 due to thermal expansion of the members forming pallet 100. As a result, some portion 210 of thickness 145 (in excess of thermal expansion) deflects out of span 205. In the illustrated implementation, portion 210 is shown near the middle of pallet 100 deflecting upward, but this is not necessarily the case. For example, downward deflection, combined upward and downward deflection, warping, twisting, and other deflections of portions of pallet 100 may occur depending on factors such as the materials and structure of pallet 100 and processing conditions.

The extent of this deflection can impact the processing of substrates. For example, if the extent of deflection is too large, substrates at different positions will be subject to different processing conditions. Devices fabricated on the different substrates will thus differ and may, at times, fall outside device-specific tolerances. Large deflections may also cause substrates to fall off or through pallet 100 and/or make moving pallet 100 difficult. For example, pallet 100 may become stuck in a processing device.

Pallet 100 avoids these difficulties by resisting deflection between sides 125, 130. In particular, the vertical movement of pallet 100 can be resisted using, for example, the specific implementations described below. For example, in some implementations, the ratio of vertical deflection of pallet 100 to the separation distance between sides 125, 130 is less than 1%, e.g., less than 0.6%, or less than 0.3%. For example, in implementations where sides 125, 130 are separated by a distance of 1800 millimeters, the vertical deflection between sides 125, 130 can be less than 10 millimeters, e.g., less than five or even three millimeters. With such small deflections, pallet 100 can be made flat enough to ensure that substrates supported by pallet 100 at different positions are subject to similar processing conditions.

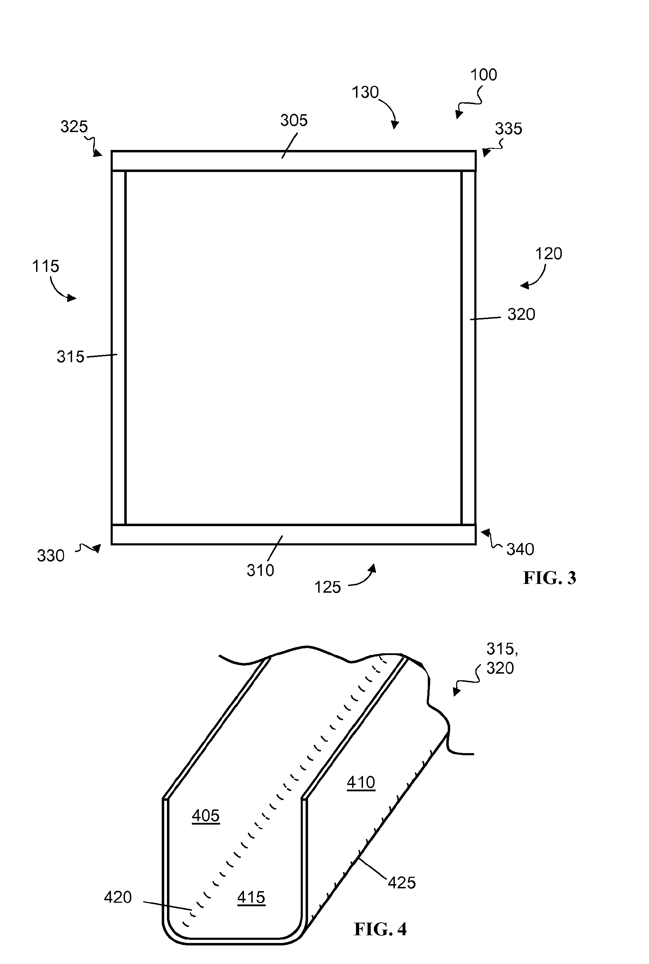

FIG. 3 is a schematic representation of an example pallet 100 that is adapted for use in high temperature processing systems. The illustrated implementation of pallet 100 has been constructed to resist bending between sides 125, 130 and ensure stability during processing. In other words, sides 125, 130 will generally stay in the same plane.

Pallet 100 includes a pair of side contact members 305, 310, a front member 315, and a back member 320. Side contact members 305, 310 are generally elongate mechanical elements that include one or more surfaces that are contacted by handling and/or storage devices. Front and back members 315, 320 are generally elongate mechanical elements that are coupled to side contact members 305, 310 at respective of couplings 325, 330, 335, 340 to form a pallet 100 that is sufficiently mechanically stable to bear the loads of substrates during handling and/or storage. As described further below, front and back members 315, 320 can be coupled directly to side contact members 305, 310 (e.g., with front and back members 315, 320 in direct physical contact with side contact members 305, 310) or front and back members 315, 320 can be coupled indirectly to side contact members 305, 310, i.e., via one or more intermediate members.

In some implementations, members 305, 310, 315, 320 are all made from metals that have low vapor pressures at the temperatures and pressures at which wafers or other substrates are to be processed In particular, the vapor pressures must be low enough that members 305, 310, 315, 320 do not contaminate the processing. For example, members 305, 310, 315, 320 can all be made from stainless steels.

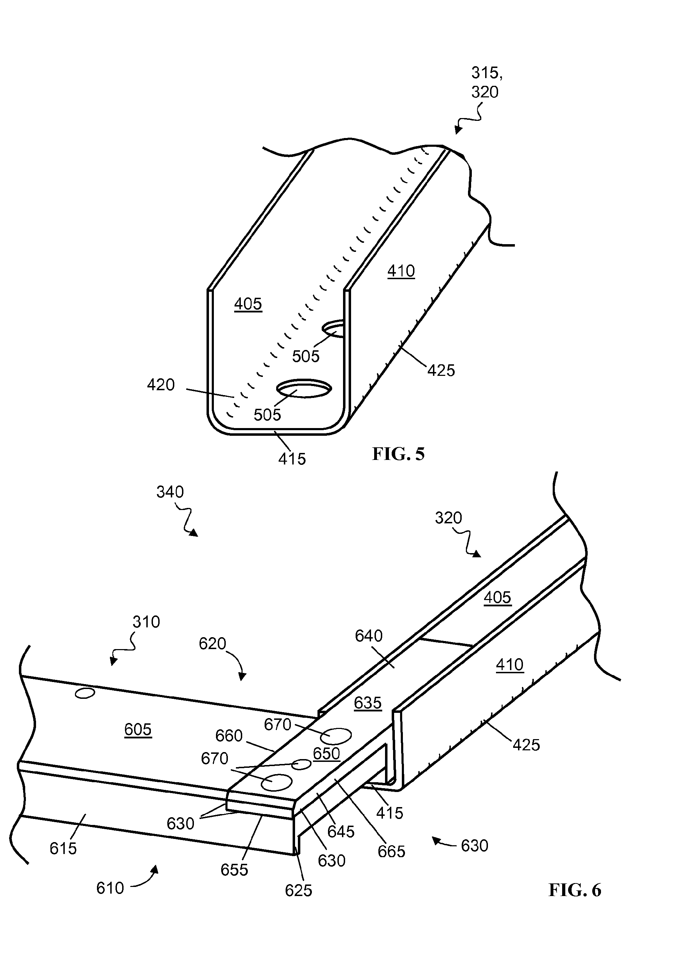

FIGS. 4, 5 are a schematic representations of examples of portions of front and back members 315, 320. The illustrated implementations of portions of front and back members 315, 320 can be used, e.g., in pallets 100 as shown in FIGS. 1, 2, 3, 10, and 15.

The illustrated implementations of front and back members 315, 320 are elongate members that have a generally U-shaped cross-section and include a pair of sides 405, 410 and a base 415 that are joined together at corners 420, 425. Sides 405, 410 both extend in the same direction away from base 415 and are generally parallel with one another and generally perpendicular to base 415. Each of sides 405, 410 can be orients toward front 115 or back 120. In the illustrated implementations, corners 420, 425 are rounded and sides 405, 410 extend approximately the same distance. In other implementations, corners 420, 425 can be square and/or sides 405, 410 can differ in length.

The generally U-shaped cross-section of front and back members 315, 320 resists bending. In particular, sides 405, 410 extend into and out of the page in the views of FIGS. 3, 10, and 15 and have relatively larger bending moments of inertia with regard to bending between sides 405, 410. Pallet 100 is stabilized by the resistance of front and back members 315, 320 to bending and sides 125, 130 generally remain in the same plane.

In some implementations, front and back members 315, 320 can be made from heat resistant material, e.g., with a relatively low thermal coefficient of expansion. In some implementations, front and back members 315, 320 can be made from heat-resistant stainless steel, such as an austenitic heat-resistant stainless steel. One example is TK 1.4828 (Type 309Si) stainless steel.

The implementation of front and back members 315, 320 illustrated in FIG. 5 defines a collection of holes 505 that extend though base 415. Holes 505 can improve the handling and/or storage of a pallet 100 at different temperatures. For example, holes 505 decrease the weight of front and back members 315, 320. As another example, in instances in which pallet 100 is introduced to processing systems that heat substrates from one side, a base 415 that defines holes 505 and that is directed toward the heater may absorb less heat.

FIG. 6 is a schematic representation of one example of coupling 340 between side contact member 310 and back member 320 in pallet 100, e.g., as shown in FIGS. 1, 2, 3, 10, and 15. Other couplings 325, 330, 335 can be made with appropriate changes in orientation and position.

The illustrated implementation of side contact member 310 is generally elongate and includes a top 605, a bottom 610, an outward longitudinal side 615, and an inward longitudinal side 620. In the assembled state, outward longitudinal side 615 faces outwardly from pallet 100 and inward longitudinal side 620 faces inwardly toward pallet 100. In the illustrated implementation, top 605, bottom 610, and sides 615, 620 are generally flat, although this is not necessarily the case.

Side contact member 310 includes a feature 625 that includes one or more surfaces at which is made with processing systems during handling and/or storage devices. In the illustrated implementation, feature 625 is a lip that extends downward from bottom 610 of side contact member 310 and dimensioned to be received in a guiding channel for directed sliding transport of pallet 100 and any loaded substrates. Side contact member 310 terminates at an end 630 that is coupled to back member 320. End 630 defines a depression that is bounded by surfaces 630.

The illustrated implementation of coupling 340 is indirect in that the coupling of contact member 310 and back member 320 is mediated by an intermediate coupling member 635. Intermediate couple member 635 includes a body 640 and an extension 645. In the illustrated implementation, body 640 is dimensioned to be received between sides 405, 410 and base 415 of back member 320. Body 640 can be fixedly joined to back member 320 in a variety of different ways, e.g., by welding. As another example, body 640 can be compression fit between sides 405, 410 of back member 320. As yet another example, body 640 can be joined to one or more of sides 405, 410 and base 415 of back member 320 by a fastener such as, e.g., a bolt, a weld, or other the like. For example, in implementations in which back member 320 includes holes 505, a bolt can be passed through holes 505 and fastened into body 640.

Extension 645 extends outwardly from body 640 and, with body 640 joined to back member 320, from back member 320. Extension 645 includes a top 650, a bottom 655, a first longitudinal side 660, and an outward longitudinal side 665. In the assembled state, outward longitudinal side 665 faces outwardly from pallet 100 and first longitudinal side 660 faces toward side contact member 310. Extension 645 is dimension to be received in the depression in end 630 of side contact member 310 that is bounded by surfaces 630. Extension 645 is fixedly coupled to side contact member 310, e.g., using one or more fasteners 670. In the illustrated implementation, fasteners 670 pass from top 650, through extension 645, and into end 630 of side contact member 310 and can be, e.g., bolts. Other implementations of fasteners 670 including, e.g., welds and bolts that pass from outward longitudinal side 665, through extension 645, and into end 630 of side contact member 310 are possible. In the illustrated implementation, longitudinal side 660 and bottom 655 contact surfaces 630, top 650 is flush with top 605 of side contact member 310, and outward longitudinal side 665 is flush with the terminus of side contact member 310 at end 630. However, this is not necessarily the case.

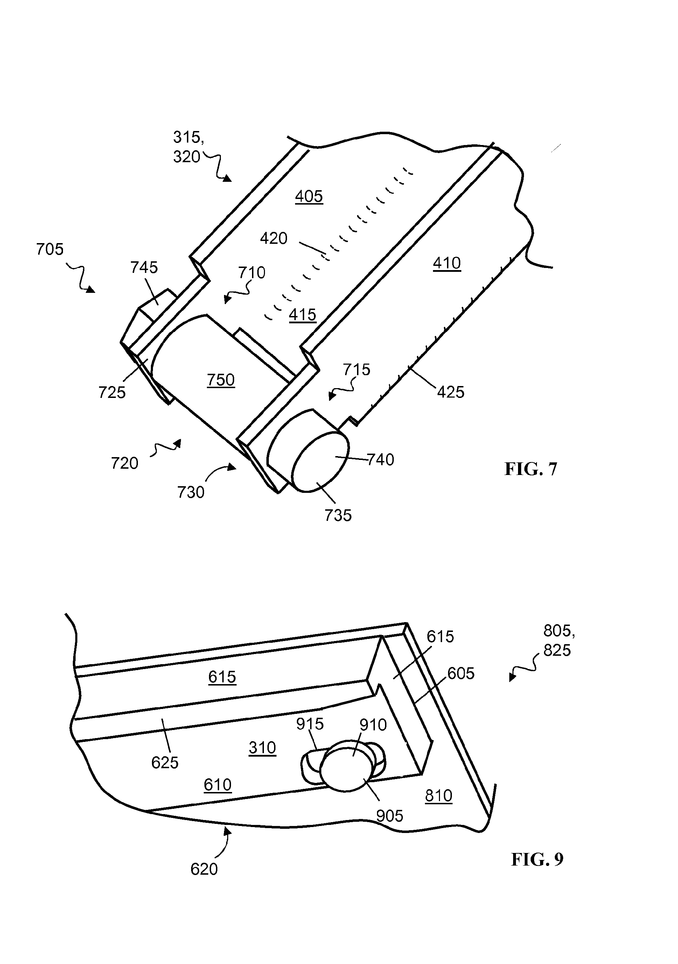

FIG. 7 is a schematic representation of an example of a portion of front and back members 315, 320. The illustrated implementation of a portion of front and back members 315, 320 can be used, e.g., in pallet 100 as shown in FIGS. 1, 2, 3, 10, and 15 and can be made from heat resistant material with a relatively low thermal coefficient of expansion, as described above. The illustrated implementation can include or omit holes 505, as the case may be.

The illustrated implementation of front and back members 315, 320 terminates at an end 705 that includes a pair of extensions 710, 715. Extension 710 extends longitudinally from side 405. Extension 715 extends longitudinally from side 410. In the illustrated implementation, extensions 710, 715 are generally planar members that are generally parallel to one another.

Extensions 710, 715 are not joined to one another, e.g., by an extension from base 415. Extensions 710, 715 define a gap 720 between an inwardly-facing surface 725 of extension 710 and an inwardly-facing surface 730 of extension 715. Extensions 710, 715 each define a hole (not visible) that is dimensioned to pass the body of a bolt 735. Bolt 735 includes a head 740 and a body (not visible). In the assembled state, the body of bolt 735 is passed through aligned holes in extensions 710, 715. Bolt 735 is fixed with a nut 745. A generally smooth cylindrical sleeve 750 can be positioned over the body of bolt 735 in gap 720. Sleeve 750 can be dimensioned to snugly fit against inwardly-facing surfaces 725, 730. Sleeve 750 facilitates loose coupling of front and back members 315, 320 to side contact members 305, 310 at respective of couplings 325, 330, 335, 340, as described further below.

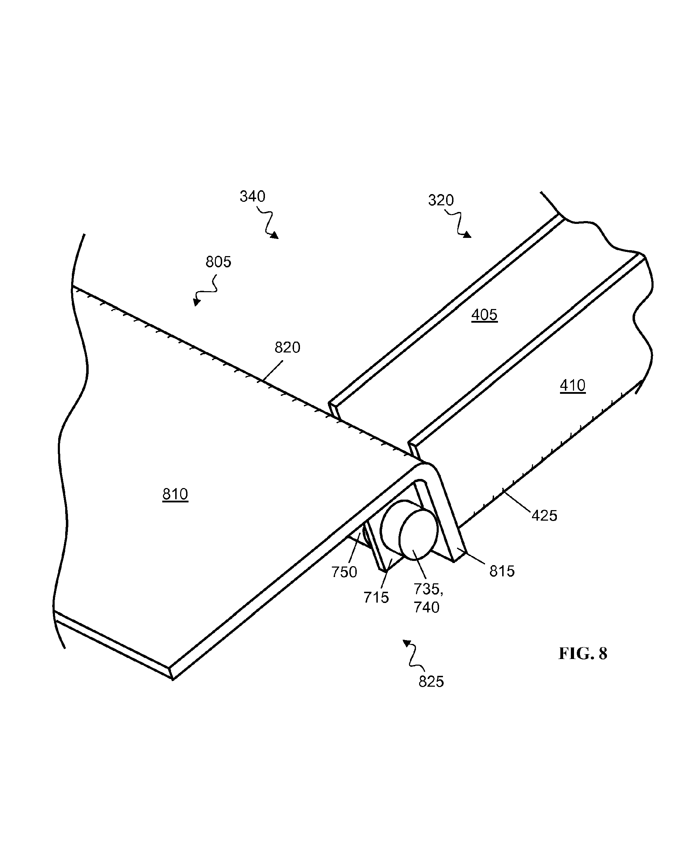

FIG. 8 is a schematic representation of one example of coupling 340 between side contact member 310 and back member 320 in a pallet 100, e.g., as shown in FIGS. 1, 2, 3, 10, and 15. Other couplings 325, 330, 335 can be made with appropriate changes in orientation and position.

The illustrated implementation of coupling 340 is indirect in that the coupling of contact member 310 and back member 320 is mediated by an intermediate coupling member 805. Intermediate coupling member 805 is an elongate member that, in the illustrated implementation, has a generally L-shaped cross section. Intermediate coupling member 805 can be made, e.g., from stainless steel, such as a relatively inexpensive austenitic general purpose 1.4301 (Type 304) stainless steel. Intermediate coupling member 805 includes a top portion 810 and a side portion 815 that are joined together at a corner 820 forming this cross section. In the illustrated implementation, corner 820 is rounded. However, square corners 820 can also be used.

Intermediate coupling member 805 terminates at an end 825 that is loosely coupled to back member 320. Side portion 815 at end 825 defines a pair of slits 830 that are each positioned to receive a respective of extensions 710, 715. Slits 830 can be relatively wider than extensions 710, 715 to accommodate longitudinal thermal expansion of intermediate coupling member 805.

To assemble coupling 340, extensions 710, 715 can be inserted into slits 830 without bolt 735, nut 745, and sleeve 750 being present. Sleeve 750 can then be positioned in gap 720 and bolt 735 inserted through aligned holes in extensions 710, 715 and through sleeve 750. Nut 745 can then be fastened to threads on the portion of the body of bolt 735 that extends out from the hole in extension 710. Bolt 735, nut 745, and sleeve 750 can prevent extensions 710, 715 from exiting slits 830 and the de-coupling of back member 320 from intermediate coupling member 805. Contact between sleeve 750 and side portion 815 couples back member 320 to intermediate coupling member 805.

The dimensions, arrangement, and materials of slits 830, extensions 710, 715, the holes defined by extensions 710, 715, sleeve 750, and side portion 815 can be selected so that there is some play in the coupling between back member 320 and intermediate coupling member 805. Such play can adapt pallet 100 for use in high temperature processing systems. In particular, with play between intermediate coupling member 805 and back member 320, the mechanical coupling of thermal expansion of intermediate coupling member 805 and/or contact member 310 into back member 320 is reduced. In effect, intermediate coupling member 805 can expand and contract over the range of the play in coupling 340 without deflecting back member 320.

FIG. 9 is a schematic representation of one example of how intermediate coupling member 805 can mediate coupling between side contact member 310 and back member 320. The illustrated implementation of side contact member 310 is generally elongate and includes top 605, bottom 610, outward longitudinal side 615, longitudinal side 620, and feature 625. End 630 of side contact member 310 terminates at outward longitudinal side 615.

Top 605 of side contact member 310 is slidably positioned against top portion 810 of intermediate coupling member 805 by a fastener 905. In the illustrated implementation, fastener 905 is a bolt with a head 910. The body of fastener 905 passes through a slotted recess 915 and into top portion 810. Fastener 905 can be fastened within top portion 810 or by a nut or other member on the other side of top portion 810. The underside of head 910 is slidable along the longitudinal edges of recess 915. Contact between the underside of head 910 and these edges can hold top 605 against top portion 810. However, relative movement between top 605 and top portion 810 in the longitudinal direction of slotted recess 915 (i.e., along the lengths of side contact member 310 and intermediate coupling member 805) can nevertheless occur. Such relative movement can help accommodate disparate thermal expansion of intermediate coupling member 805 and side contact member 310. Other approaches to slidably positioning side contact member 310 against top portion 810 of intermediate coupling member 805 are possible including, e.g., slotted rails. In some implementations, a fastener can fixedly couple intermediate coupling member 805 to side contact member 310 at their respective longitudinal midpoints and differential thermal expansion of intermediate coupling member 805 and side contact member 310 accommodated by slidable coupling at end 630.

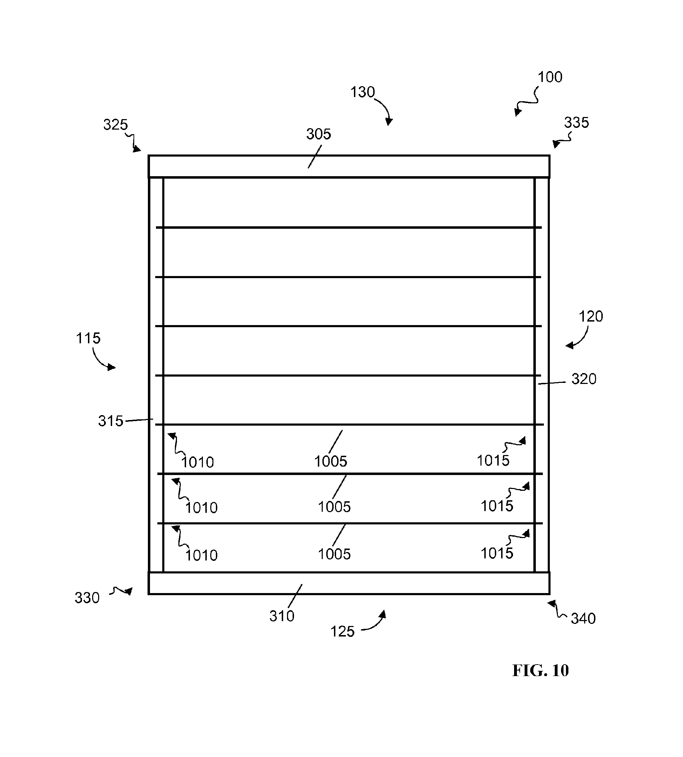

FIG. 10 is a schematic representation of an example pallet 100 that is adapted for use in high temperature processing systems.

In addition to side contact members 305, 310, front member 315, and back member 320, the illustrated implementation of pallet 100 also includes a collection of support beams 1005. Support beams 1005 are generally elongate members that are dimensioned to be positioned in pallet 100 to support loads at intermediate positions between front member 315, back member 320, and side contact members 305, 310. The supported loads can include substrates, with or without additional members such as, e.g., substrate mounting plates, as described further below. Support beams 1005 can be made , e.g., from stainless steel, such as a relatively inexpensive austenitic general purpose 1.4301 (Type 304) stainless steel.

In the illustrated implementation, support beams 1005 extend across the entire span between front member 315 and back member 320. This is not necessarily the case. For example, in other implementations, support beams 1005 can extend across some portion of the span between members 315, 320 and can be supported at intermediate locations between members 315, 320. As another example, support beams 1005 can extend between side contact members 305, 310.

Each support beams 1005 includes a first end 1010 and a second end 1015. At least one of first end 1010 and second end 1015 is slidably supported to accommodate changes in the dimensioning of pallet 100. As described above, ends 1010, 1015 can be coupled to respective of members 315, 320 or to intermediate members positioned between members 315, 320.

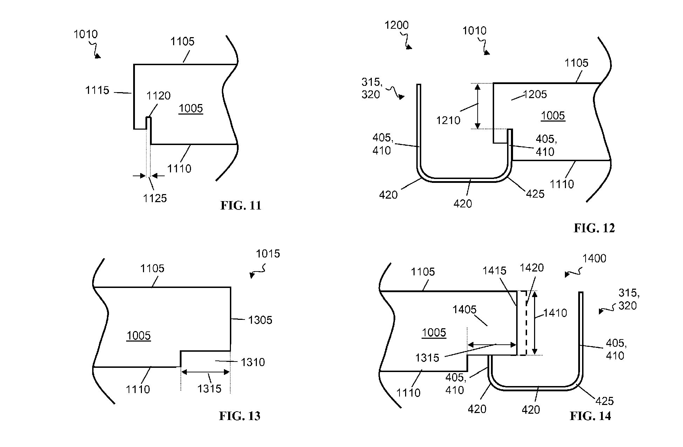

FIG. 11 is a schematic representation of an example end 1010 of a support beam 1005 and FIG. 12 is a schematic representation of a cross-section of a coupling 1200 of end 1010 to one of members 315, 320.

The illustrated implementation of support beam 1005 is a generally strip-shaped member having a top 1105, a bottom 1110, and an end 1115. The thickness of support beam 1005 (i.e., into and out of the page) is thus much smaller than the separation between top 1105 and bottom 1110 and the separation between end 1115 and the other longitudinal end 1305 (FIG. 13). A receptacle 1120 having a width 1125 is defined at end 1010 of support beam 1005. Width 1125 is dimensioned to receive a corresponding of sides 405, 410 of one of members 315, 320 snugly enough to reduce relative movement between support beam 1005 and the respective member 315, 320 but not so tightly that differential thermal expansion of receptacle 1120 and support beam 1005 unduly stresses pallet 100.

The corresponding side 405, 410 of member 315, 320 includes a slit-shaped receptacle 1205 that extends from the top of the corresponding side 405, 410 a distance 1210 toward base 420. The width of receptacle 1205 (i.e., into and out of the page) is dimensioned to maintain support beam 1005 upright, i.e., with top 1105 up and bottom 1110 down, even when loads are supported.

FIG. 13 is a schematic representation of an example end 1015 of a support beam 1005 and FIG. 14 is a schematic representation of a cross-section of a coupling 1400 of end 1015 to one of members 315, 320.

In the illustrated implementation, a cut-out 1310 is defined at an end 1305 of support beam 1005. Cut-out 1310 opens on bottom 110 at end 1305 and extends a distance 1315 from end 1305 toward end 1115 (FIG. 11). Distance 1315 is larger than width 1125 of receptacle 1120 at end 1115.

Distance 1315 is dimensioned to accommodate longitudinal thermal expansion of support beam 1005. In particular, the corresponding side 405, 410 of member 315, 320 includes a slit-shaped receptacle 1405 that extends from the top of the corresponding side 405, 410 a distance 1410 toward base 420. The width of receptacle 1405 (i.e., into and out of the page) is dimensioned to maintain support beam 1005 upright, i.e., with top 1105 up and bottom 1110 down, even when loads are supported. The portion of end 1305 above cut-out 1310 can slide longitudinally within slit-shaped receptacle 1405 (e.g., so that end 1305 moves between a first position 1415 and a second position 1420) to accommodate longitudinal thermal expansion of support beam 1005.

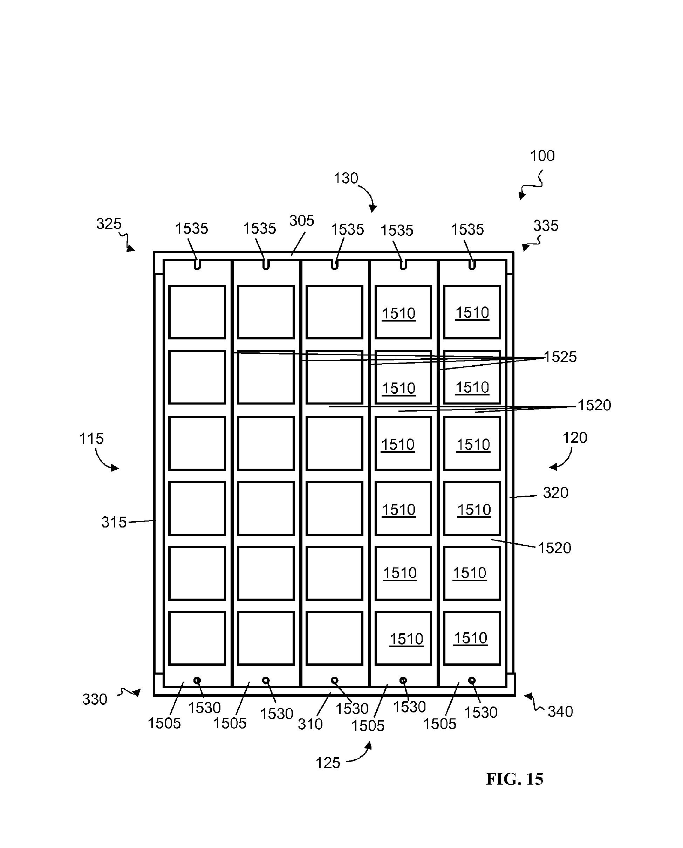

FIG. 15 is a schematic representation of an example pallet 100 that is adapted for use in high temperature processing systems.

In addition to side contact members 305, 310, front member 315, and back member 320 (alone or in combination with support beams 1005), the illustrated implementation of pallet 100 also includes a collection of substrate mounting plates 1505. Substrate mounting plates 1505 provide one or contact surfaces for supporting substrates onto pallet 100 and can be made , e.g., from stainless steel, such as a relatively inexpensive austenitic general purpose 1.4301 (Type 304) stainless steel. In the illustrated implementation, each substrate mounting plate 1505 defines a collection of openings 1510 though which relevant portions of mounted substrates are exposed to processing conditions.

In the illustrated implementations, substrate mounting plates 1505 are generally elongate members with the openings 1510 arranged longitudinally adjacent one another. The longitudinally arranged openings 1510 are separated by members 1520. In the illustrated implementation, substrate mounting plates 1505 extend across the entire span between side contact members 305, 310, with or without support from support members 1005. In other implementations, substrate mounting plates 1505 can have different shapes and/or can extend across some portion of the span between side contact members 305, 310 or between front 115 and back 120 and be supported by intermediate members.

In the illustrated implementation, substrate mounting plates 1505 are laterally aligned generally parallel with one another and have sides 1525 that contact one another. In other implementations, a gap can exist between sides 1525 of neighboring substrate mounting plates 1505 to accommodate thermal expansion and ensure, e.g., that deposited materials do not form fragile bridges between neighboring substrate mounting plates 1505 that could potentially contaminate processing devices.

Substrate mounting plates 1505 can be coupled directly to side contact members 305, 310 or indirectly via one or more intermediate members. For example, substrate mounting plates 1505 can be coupled to top 605 of side contact member 310 or to top portion 810 of intermediate coupling member 805. The coupling between substrate mounting plates 1505 and members 315, 320 can be made to accommodate longitudinal thermal expansion of substrate mounting plates 1505 that differs from the longitudinal thermal expansion of members 315, 320. For example, substrate mounting plates 1505 can be fixedly coupled to one of side contact members 305, 310 and slidably coupled to the other of side contact members 305, 310. In the illustrated implementation, the fixed couplings 1530 can include bolts or screws that are received snugly in receptacle on substrate mounting plates 1505, whereas the slidable couplings 1535 can include bolts or screws that are received in slit receptacles on substrate mounting plates 1505. Substrate mounting plates 1505 can thus expand longitudinally while remaining coupled to both side contact members 305, 310. Indeed, since each coupling 1530 fixes a respective substrate mounting plates 1505 to the remainder of pallet 100 at a single point, differential thermal expansion and contraction of substrate mounting plates 1505 and the remainder of pallet 100 can be accommodated.

In use, pallet 100 can be introduced into a variety of different processing devices to transport loaded substrates into the devices. For example, in some instances, pallets 100 are introduced into sputtering devices. The sputtering devices may operate at temperatures, e.g., in the vicinity of 500°C. Contamination of carrier 100 during such processing generally results.

In some implementations, substrate mounting plates 1505 have features that are adapted for positioning and holding substrates at particular positions relative to portions of the processing devices. Examples of such positioning and holding features include lips, raised portions, or other elements. In some implementations, positioning and holding features are found on both sides of substrate mounting plates 1505 so that substrate mounting plates 1505 which have been preferentially contaminated by processing on one side can be de-coupled from the remainder of pallet 100, flipped over, and re-coupled with a less-contaminated side exposed for positioning and holding substrates.

A number of implementations have been described. Nevertheless, it will be understood that various modifications may be made. Accordingly, other implementations are within the scope of the following claims.

## Claims

1. A device comprising:
a generally planar substrate pallet (100) having an front, a back, and pair of sides, wherein the distance between the front and the back and the distance between the sides are significantly longer than the thickness of the substrate pallet, wherein a ratio of vertical deflection of the substrate pallet to the distance between the sides at temperatures used in high temperature processing systems relative to room temperature is less than 1%.

2. The device of claim 1, wherein the ratio of vertical deflection to the distance between the sides is less than less than 0.3%.

3. The device of claim 1, wherein the bending moment of inertia of the substrate pallet distance between the sides is larger than the bending moments of inertia between the front and the back.

4. The device of claim 1, wherein the generally planar substrate pallet (100) comprises:
a pair of elongate contact members (305, 310); and
at least one elongate cross member (315, 320) coupled to each of the contact members.

5. The device of claim 4, wherein the elongate contact members and the at least one elongate cross member all comprise heat resistant steel.

6. The device of claim 4, wherein the at least one elongate cross member has a U-shaped cross-section.

7. The device of claim 4, wherein the elongate contact members are coupled to the at least one elongate cross member by intermediate members.

8. The device of claim 7, wherein each of the intermediate members (810) has an L-shaped lateral cross-section.

9. The device of claim 7, wherein each of the intermediate members (635) comprises:
a body (640) coupled to a respective of the cross members; and
an extension (645) coupled to a respective of the at least one elongate contact members.

10. The device of claim 4, wherein the at least one elongate cross member comprises a pair of elongate cross members disposed along outer boundaries of the y-dimension of the substrate pallet.

11. The device of claim 4, further comprising at least one elongate support beam (1005) disposed across the cross member but slidable relative thereto.

12. The device of claim 11, wherein:
the cross member comprises a receptacle (1405) dimensioned to receive a portion of the elongate support beam (1005); and
the portion of the elongate support beam (1005) is slidably received in the receptacle.

13. The device of claim 1, further comprising a generally planar substrate mounting plate (1505) coupled to the substrate pallet (100) at a single fixed point.

14. The device of claim 13, wherein the substrate mounting plate (1505) is coupled to a pair of elongate contact members (305, 310) disposed along outer boundaries of the x-dimension of the substrate pallet.

15. A method comprising:
loading substrates onto a device according to any one of claims 1 to 14;
transporting the substrate pallet (100) and substrates loaded thereon into a sputtering deposition device with the x-dimension generally orthogonal to the direction of transport and the y-dimension generally parallel to the direction of transport; and
sputter depositing a film onto the substrates in the sputtering deposition device.
